(19) Europäisches Patentamt

European Patent Office

Office européen des brevets

(11) **EP 1 442 088 B1**

(12) **EUROPÄISCHE PATENTSCHRIFT**

(45) Veröffentlichungstag und Bekanntmachung des Hinweises auf die Patenterteilung:
**01.06.2005 Patentblatt 2005/22**

(21) Anmeldenummer: **02774462.2**

(22) Anmeldetag: **16.10.2002**

(51) Int Cl.⁷: **C09D 11/10**, C08F 290/02, C09D 4/06, G03F 3/10, G03F 7/11, C08F 290/06, C09D 4/00

(86) Internationale Anmeldenummer:
**PCT/DE2002/003914**

(87) Internationale Veröffentlichungsnummer:
**WO 2003/035777 (01.05.2003 Gazette 2003/18)**

(54) **TIEFDRUCKVERFAHREN MIT RADIKALISCH HÄRTBAREN DRUCKFARBEN**

GRAVURE PRINTING PROCESS USING FREE RADICAL CURABLE PRINTING INKS

HELIOGRAVURE AVEC ENCRES D'IMPRIMERIE A POLYMERISATION RADICALAIRE

(84) Benannte Vertragsstaaten:
**AT BE BG CH CY CZ DE DK EE ES FI FR GB GR IE IT LI LU MC NL PT SE SK TR**

(30) Priorität: **19.10.2001 DE 10151661**

(43) Veröffentlichungstag der Anmeldung:
**04.08.2004 Patentblatt 2004/32**

(73) Patentinhaber:
• **Druckfarbenfabrik Gebr. Schmidt GmbH
60489 Frankfurt (DE)**
• **Flint Ink Corporation
Ann Arbor, MI 48105-2773 (US)**

(72) Erfinder: **SCHMIDT, Helmut
61462 Königstein (DE)**

(74) Vertreter: **Jany, Peter, Dr.
Dr. H.-P. Pfeifer Dr. P. Jany
Patentanwälte
Beiertheimer Allee 19
76137 Karlsruhe (DE)**

(56) Entgegenhaltungen:
**EP-A- 0 511 860          EP-A- 0 603 642
EP-A- 0 632 111          EP-A- 0 984 045
GB-A- 2 255 778          GB-A- 2 256 874
US-A- 5 418 016          US-A- 5 492 791
US-A- 5 547 811**

**Beschreibung**

Die Erfindung betrifft ein Druckverfahren mit radikalisch polymerisierbaren Druckfarben für den Rotationstiefdruck, deren Polymerisation durch aktinische Strahlung ausgelöst wird. Gebräuchliche aktinische Strahlungsquellen sind beispielsweise UV-Lampen und Laser.

Werden in der Drucktechnik hohe Druckgeschwindigkeiten gefordert, so kann der Druckträger (Bedruckstoff, Substrat) im Rotationstiefdruck bedruckt werden. Bei diesem Verfahren wird ein metallischer Druckzylinder eingesetzt, der an der Oberfläche eingravierte oder geätzte Näpfchen aufweist. Die Näpfchen nehmen die Druckfarbe auf und durch Abrollen des Druckzylinders wird diese unter Entleerung der Näpfchen auf den Druckträger übertragen.

Bei gravierten Näpfchen wird das Farbvolumen durch die Näpfchentiefe und die Basisfläche bestimmt, wobei die erzielte Schichtdicke und die Fläche des Farbpunktes geometriebedingt von beiden Größen abhängt. Das bedeutet, daß tiefere Näpfchen auch über eine größere Basisfläche verfügen und ein größeres Farbvolumen übertragen.

Ähnliches gilt auch für geätzte Näpfchen. Hier gibt es einen wesentlichen Unterschied zu gravierten Näpfchen: Diese Näpfchen weisen einen höheren Entleerungsgrad als gravierte Näpfchen auf, weil ihre Spitze durch die Ätzung gerundet ist.

Herkömmliche Druckfarbensysteme für den Tiefdruck bestehen aus Farbmittel, Bindemittel, Lösungsmittel und Additiven zur Verbesserung der Benetzung und Entschäumung. Als Lösungsmittel werden neben aromatischen Kohlenwasserstoffen wie Toluol auch Ketone, Alkohole und Ester verwendet.

Aus Gründen des Umweltschutzes gibt es große Anstrengungen, die Emission von Lösungsmitteln im Tiefdruck zu vermeiden und durch lösungsmittelfreie oder zumindest lösemittelreduzierte Farbsysteme zu ersetzen.

In dem Dokument US 5,429,841 wurde vorgeschlagen, Anteile organischer Lösungsmittel in Tiefdruckfarben, die nicht mit Wasser mischbar sind, teilweise durch Wasser zu ersetzen. Die Öl/Wasser-Emulsion enthält aber immer noch große Mengen organische Lösungsmittel, so daß von umweltverträglichen Druckfarben nicht gesprochen werden kann.

Gemäß der EP-0686509 kann eine lösungsmittelfreie strahlungshärtende Tiefdruckfarbe mit einer für das Tiefdruckverfahren üblichen Viskosität von 100 mPas dadurch erreicht werden, daß niederviskose Reaktionsverdünner eingesetzt werden. Diese Reaktionsverdünner werden durch eine Polymerisation, die durch aktinische Strahlung induziertet wird, in die Bindemittelmatrix eingebunden. Vorgeschlagen wird ein UV-härtendes Epoxid/Reaktionsverdünner-System, das durch kationische Photopolymerisation vernetzbar ist. Wenn man von einer für den Tiefdruck üblichen Viskosität ausgeht und als Reaktivverdünner Vinyläther einsetzt, so ist damit zu rechnen, daß die Reaktivität der Tiefdruckfarbe zu stark vermindert wird und nach der Polymerisation noch erhebliche Anteile des Reaktivverdünners nicht ausreagiert sind, wodurch die Qualität der Farbschicht (z.B. die mechanischen Eigenschaften) verschlechtert wird.

In dem Dokument EP-0813976-B1 wurde vorgeschlagen, Lösungsmittel vollständig gegen Wasser auszutauschen, wobei das Bindemittel in Form einer Dispersion bzw. Emulsion mit Acrylat, bzw. Epoxidsysteme vorliegt, das nach der Verdunstung des Wasser polymerisierbar ist. Der Vorteil dieses Farbsystems ist, daß die erforderliche Näpfchentiefe des Tiefdruckzylinders bei Anwendung eines wasserverdünnbaren UV-Farbsystems die gleiche ist, die auch beim Einsatz von auf Lösungsmitteln basierenden Tiefdruckfarben gewählt wird. Nachteilig ist allerdings, daß vor der aktinischen Härtung das Wasser durch Konvektions-, IR-, oder Hochfrequenztrocknung vollständig entfernt werden muß, um einen beständigen Farbfilm auf dem Substrat zu erhalten.

In der Publikation EP 0839667 A1 wurde vorgeschlagen, zur Reduzierung der Viskosität der strahlungshärtenden Druckfarbe einen Anteil von 3-25% flüchtiger Lösungsmittel zu verwenden. Dieser Weg scheint für ein umweltfreundliches Druckfarbensystem kaum gangbar, da bei der Verdruckung großer Farbmengen erhebliche Mengen an Lösungsmittel in die Atmosphäre gelangen. Auch können eventuell vorhandene Lösungsmittelreste nach der Strahlungshärtung in dem gehärteten Farbfilm zurückbleiben, die zu einer Verschlechterung der Eigenschaften des gehärteten Farbfilmes führen können.

Tiefdruckfarben erfordern in der Regel eine Viskosität, die im Vergleich zu anderen Druckfarbensystemen gering ist und die häufig mit einem Wert zwischen 50 und 100 mPas angegeben wird. Diese niedrigen Viskositäten sind, abgesehen von dem in der EP-0686509-A1 vorgeschlagenen Epoxid-System, das einen extrem hohen Anteil an Reaktivverdünner enthält, bisher nur bei konventionellen Tiefdruckfarben, das heißt unter Einsatz von organischen Lösungsmitteln, und bei Farbsystemen, die wasserverdünnbare Dispersionen bzw. Emulsionen als Bindemittelbestandteile enthalten, erreicht worden.

Im letztgenannten Fall, wo praktisch das organische Lösungsmittel durch Wasser substituiert wird, können relativ leicht sehr niederviskose Druckfarbensysteme realisiert werden. Wasser als Fließmittel hat eine sehr niedrige Viskosität und bestimmt in solchen mehrphasigen Systemen die Viskosität.

Werden wässrige Dispersionen oder Emulsionen für die Formulierung von Tiefdruckfarben verwendet, so sind zwei Fälle zu unterscheiden:

a) Der Einsatz von physikalisch trocknenden Dispersionen und Emulsionen stellt eine gebräuchliche Möglichkeit dar. Die Trocknung erfolgt durch Verdunstung des Fließmittels Wasser und Verschmelzung der Polymerteilchen (Koaleszenz). Dieser Vorgang ist u.a. von der Mindestfilmbildungstemperatur (MFT) des Bindemittelsystems und, falls vorhanden, vom Typ des Lösungsmittels abhängig.

b) Bilden strahlungshärtende Dispersionen oder Emulsionen Hauptbestandteile von Tiefdruckfarben, so ist es erforderlich, vor der Strahlungshärtung das Fließmittel Wasser durch Verdunstung vollständig zu entfernen. Erst danach ist eine strahlungsinduzierte Polymerisation möglich, die zur optimalen Ausbildung der physikalischen und chemischen Eigenschaften des eingesetzten Bindemittels führt. Die physikalische Trocknung des Farbsystems vor der Strahlungshärtung ist recht schwierig, erfordert eine höhere Temperatur und eine längere Verweilzeit in der Trocknungszone. Häufig werden für derartige strahlungshärtende Farbsysteme PUR-Dispersionen eingesetzt, die im günstigsten Fall bei einer Verweilzeit von einer Sekunde in der Trocknungszone eine Trocknungstemperatur von 300 °C erfordern.

Bei der Anwendung wasserverdünnbarer strahlungshärtbarer Systeme unterscheidet sich die Näpfchentiefe des Tiefdruckzylinder nicht grundsätzlich von der, wie sie bei lösungsmittelhaltigen Farbsystemen üblich ist. Damit ist auch die Farbmittelkonzentration beider Systeme praktisch gleich hoch.

Allgemein wird davon ausgegangen, daß Farbsysteme für den Tiefdruck eine ideales Viskositätsverhalten (newtonisch) aufweisen sollen. Untersuchungen mit einem Hochdruckkapillarviskosimeter haben aber ergeben, daß rotative Tiefdruckfarben ein elastisches Verhalten besitzen, also strukturviskos sind. Zu beachten ist ferner, daß das Schergefälle bei diesem Druckverfahren mit $10^5$ - $10^7$ $sec^{-1}$ sehr hoch ist, wobei die Kontaktzeit (Dauer der Näpfchenentleerung) mit 1 μsec klein bleibt.

Aufgabe der Erfindung ist es, ein Verfahren für den rotativen Tiefdruck zu schaffen, bei dem eine strahlungshärtbare und umweltverträgliche, also lösungsmittelfreie Druckfarbe verwendet wird und der Energieaufwand für die Trocknung nicht so hoch ist, wie bei Anwendung eines konventionellen wasserverdünnbaren strahlungshärtbaren Farbsystems.

Diese Aufgabe wird erfindungsgemäß durch ein Druckverfahren mit den Merkmalen des beigefügten Anspruchs 1 gelöst. Eine entsprechende Tiefdruckfarbe ist Gegenstand des Anspruchs 14.

Bevorzugte Ausgestaltungen und Weiterbildung der Erfindung ergeben sich aus den Ansprüchen 2 bis 13 sowie 15 bis 19 und der nachfolgenden Beschreibung.

Eine erfindungsgemäße Tiefdruckfarbe mit einem strahlungshärtbaren Farbsystem, daß die Anforderungen des Tiefdrucks, insbesondere die niedrige Viskosität erfüllt und eine hohe Druckgeschwindigkeit (200 m/min) ermöglicht, umfaßt also 20 - 75 Gew.-%, vorzugsweise 30 - 70 Gew.-% eines durch aktinische Strahlung härtbaren Bindemittelsystems, 2 - 25 Gew.-%, vorzugsweise 4 - 15 Gew.-% eines Vinyläthers, 0 - 45 Gew.-% eines Farbmittels, 2 - 15 Gew.-%, vorzugsweise 2 - 10 Gew.-% eines radikalischen Photoinitiators und 0 - 10 Gew.-% Additive.

Vorzugsweise bildet das niedermolekulare Bindemittel in Form Oligoäther-, Oligoester- oder Urethanacrylate mit einem Molekulargewicht unterhalb 1500 die Hauptkomponente für das strahlungshärtbare Bindemittelsystem, wobei die Viskosität bei Raumtemperatur jeder eingesetzten Acrylat-Komponente vorzugsweise nicht über 500 mPas liegen sollte.

In einer weiteren Ausgestaltung kann vorteilhafterweise ein kleiner Anteil von höhermolekularen Präpolymeren der vorstehend angegebenen Klassen mit einem höheren Molekulargewicht zugesetzt werden, um bestimmte Eigenschaften, wie zum Beispiel die Haftung auf schwierigen Untergründen zu verbessern. Ihr Anteil ist vorzugsweise kleiner als 10 Gew.-%, um die Viskosität der Formulierung nicht wesentlich zu erhöhen.

Nach einem anderen vorteilhaften Merkmal wird vorgeschlagen, daß die Druckfarbe einen Anteil von 0 - 75 Gew.-% eines monomeren Reaktivverdünners aus Acrylsäureester enthält. Zur Gruppe Reaktivverdünner gehören monomere Acrylate, vorzugsweise mit mindestens drei Acrylsäureestergruppen, einem Molekulargewicht unter 400 und einer Viskosität kleiner 500 mPas.

Da Monomere mit nur einer Acrylsäureestergruppe zwar eine sehr niedrige Viskosität aufweisen und einen sehr guten Verdünnungseffekt besitzen, ist im Gegensatz zu den höherfunktionellen Acrylsäureestern ihre Reaktivität aber in der Regel viel zu gering, um sie in Formulierungen für den strahlungshärtenden Tiefdruck einzusetzen.

Das Gesagte gilt im Prinzip auch für difunktionelle Acrylsäureester, die in der Regel reaktiver als monofunktionelle Actylate sind, aber auf Grund ihrer Reaktivität nur in einem beschränkten Maße in strahlungshärtende Tiefdruckfarben eingesetzt werden konnen. Ein Beispiel hierfür ist 1,6-Hexandiacrylsäureäthylester (HDDA), der über einen beachtlichen Verdünnungseffekt verfügt, aber vorzugsweise nur mit einem maximalen Anteil von 10% am Bindemittel eingesetzt wird.

Nach einem vorteilhaften Merkmal wird vorgeschlagen, daß die Druckfarbe als niedermolekulares Bindemittel ein oder mehrere Polyesteracrylate, Polyätheracrylate einschließlich aminomodifizierter Typen oder Urethanacrylate mit einem Molekulargewicht kleiner 1500 und einer Acrylatfunktionalität von mindestens 2, vorzugweise 3 bis 4 enthält.

Nach einem anderen vorteilhaften Merkmal kann vorgesehen sein, daß die Druckfarbe ein Polyester- oder ein Polyätheracrylat einschließlich einer aminomodifizierten Type, ein Epoxyacrylat oder ein Polyurethanacrylat mit einem Molekulargewicht größer als 1500 und einer Acrylatfunktionalität von mindestens 2, vorzugsweise 3 bis 4 enthält, wobei deren Anteil maximal 10 Gew.-% an der Summe aus Bindemitteln und Pigment beträgt.

Desweiteren wird nach einem anderen vorteilhaften Merkmal vorgeschlagen, daß das Bindemittel der Druckfarbe eines oder mehrerer folgender Monomere enthält: HDDA, Di- oder Tripropylenglycoldiacrylat (DPGDA,TPGDA), Trimethylolpropan- di-oder Triacrylat (TMPDA,TMPTA) einschließlich deren ethoxyliete bzw. propoxylierte Abkömmlinge, Pentaerythrioltriacrylat (PETIA), bzw. Pentaerythrioltetraacrylat (PETTA) einschließlich deren ethoxyliete bzw. propoxylierte Derivate (wie z.B. PPTTA), Ditrimethylolpropantetraacrylat (DiTMPTTA), Tris(2-Hydroxyethyl)isocyanurattriacrylat (THEICTA) und triacryliertes Glycerol (GPTA).

Vorteilhafterweise wird die Strahlungshärtung des erfindungsgemäßen Druckverfahrens in inerter Atmospähre, insbesondere unter Stickstoff- oder Kohlendioxid-Atmospähre durchgeführt.

Die wesentliche Komponente in der Druckfarbenformulierung ist der Vinyläther, der die Viskosität des strahlungshärtenden Farbsystems so reduziert, daß das Farbsystem im Tiefdruck verdruckbar ist. In der Regel kann sowohl Triäthylenglycoldivinyläther (DVE-3) oder auch Diäthylenglycoldivinyläther (DVE-2) eingesetzt werden, der zwar die Viskosität etwas stärker reduziert als (DVE-3) aber einen deutlich wahrnehmbaren Eigengeruch besitzt. Anteile in der Höhe bis zu ca. 11% an der Gesamtformulierung beeinflussen die Reaktivität des Farbsystem nicht. Höhere Anteile an Vinyläthern verringern natürlich die Viskosität der Formulierung weiter, sollten aber vermieden werden, um das Auftreten unerwünschter Reaktionsprodukte bei der Photopolymerisation zu verhindern.

Allgemein ist es vorteilhaft, wenn die Druckfarbe als Vinyläther im wesentlichen di- oder höherfunktionelle Vinyläther, insbesondere Butandioldivinyläther (BDDVE), Diäthylenglycoldivinyläther (DVE-2), Triäthylenglycoldivinyläther (DVE-3), Cyclohexandimethanoldivinyläther (CHDVE), Hexandioldivinyläther (HDDVE), Diisopropylglycoldivinyläther (DPE-2), Triisopropylglycoldivinyläther (DPE-3) oder Trimethylolpropantrivinyäther (TMPTVE) enthält.

Nach einem anderen Merkmal ist es vorteilhaft, wenn die Druckfarbe als Vinyläther monomere Vinyläther oder Hydroxyvinyläther, insbesondere 2-Ethylhexylvinyläther (EHVE), Octadecylvinyläther (ODVE), Cyclohexylvinyläther (CVE), Cyclohexandimethanolmonovinyläther (CHMVE), Dodeclvinyläther (DDVE) oder Diäthylenglycolmonovinyläther (MVE-2) enthält.

Als Pigmente und Photoinitiatoren werden vorteilhafterweise die gleichen handelsüblichen Produkte eingesetzt, wie sie allgemein in UV-härtenden Druckfarbensystemen verwendet werden.

Die Druckfarbe kann vorteilhafterweise als Additiv zur Verbesserung der Haftung auf Kunststoff- oder Metallfolien Silane mit einem Anteil zwischen 0,5 und 5 Gew.-%, vorzugsweise 1-3 Gew.-%, enthalten. Die Gruppe der Additive umfaßt die üblichen Hilfsmittel, die bei Druckfarben häufig eine große Bedeutung haben. Hierzu gehören Entschäumer-, Verlauf-, Netz- und Dispergiermittel. Eine besondere Gruppe stellen Haftvermittler auf Silanbasis dar, die bei bestimmten schwerbedruckbaren Substrate die Haftung entscheidend verbessern. Allerding muß dabei berücksichtigt werden, daß der Zusatz von Silanverbindungen in der Regel zu einer mehr oder weniger ausgeprägten Viskositätserhöhung führt, wodurch eventuell die Verdruckbarkeit der Tiefdruckfarbe beeinträchtigt wird.

Im Rahmen der Erfindung sind insbesondere folgende Silane bevorzugt: 3-Aminopropyltrimethoxysilan, 3-Aminopropyltriethoxysilan, N-(n-Butyl)-3-aminopropyltrimethoxysilan, polyglykolethermodifiziertes Aminosilan, N-Aminoethyl-3-aminopropylmethyldimethoxysilan, 3-Aminopropylmethyldiethoxysilan, 3-Ureidopropyltriethoxysilan, N-Aminoethyl-3-aminopropyltrimethoxysilan, triaminofunktionelles Propyltrimethoxysilan, 3-(4,5-Dihydroimidazolyl)-propyltriethoxysilan, 3-Methacryloxypropyltrimethoxysilan, 3-Glycidyloxypropyltrimethoxysilan, 3-Glycidyloxy-propyltriethoxysilan, 3-Mercaptopropyltrimethoxysilan, Polyethersilan, Vinyltrichlorsilan, Vinyltrimethoxysilan, Vinyltriethoxysilan, Vinyltris(2-methoxyethoxy)silan.

In der Regel führt der Einsatz von Vinyläthern in strahlungshärtenden Tiefdruckfarben zu Druckfarben, die im Hinblick auf ihre rheologischen Eigenschaften gut verdruckbar sind. Trotzdem kann es vorteilhaft sein den Druckzylinder auf Temperaturen bis 50 °C zu erwärmen, um ein einwandfreies Druckbild zu erreichen. Dieses ist eventuell dann erforderlich, wenn i) durch Zusatz von 1-3% Silan-Haftvermittlern sich die Viskosität des Farbsystems um ca. 20-50% erhöht hat, ii) die Benetzung des zu bedruckenen Substrats nicht einwandfrei ist, so daß das Druckbild Mängel aufweist und iii) bei sehr hohen Geschwindigkeiten oberhalb 150 m/min gedruckt wird.

Im Rahmen der Erfindung ist es vorteilhaft, wenn die Viskosität der strahlungshärtbaren Druckfarbe bei 20 °C und einem Schergefälle von D=100 sec$^{-1}$ kleiner als 305 mPas ist und die Viskosität durch Erwärmung des Druckzylinders bis auf 50 °C auf einen Wert unter 100 mPas (D=100 sec$^{-1}$) reduzierbar ist.

Ein großer Unterschied der erfindungsgemäß verwendeten Druckfarbe besteht zu den lösungsmittelhaltigen Farbsystemen gerade darin, daß die strahlungshärtenden Systeme keine flüchtigen Bestandteile wie Lösungsmittel enthalten. Dieses hat für den gedruckten Farbpunkt folgende Konsequenz: Würde die Näpfchentiefe des Druckzylinders dem UV-Farbsystem nicht angepaßt, hätte dieses im Vergleich zu den lösungsmittelhaltigen Farben eine höhere Schichtdicke für den ausgedruckten Farbfilm zur Folge. Dieses ist aber in der Regel nicht erwünscht, so daß die Näpfchentiefe bei der Verwendung von strahlungshärtenden Farben und lösungsmittelfreien reduziert werden muß. Allerdings ist es dann auch erforderlich die Farbmittelkonzentration gegenüber den lösungsmittelhaltigen Farbsystemen zu erhöhen.

Die Verhältnisse werden für kegel- und pyramidenförmige Näpfchen mit gleichgroßer Basisfläche durch

$$h_{UV} = \frac{C_L}{C_{UV}} \cdot h_L$$

beschrieben, mit der Näpfchentiefe h für lösungsmittelhaltige Systeme (Index L), strahlungshärtende Systeme mit dem Index UV und den Konzentrationen c.

Dabei ist zu berücksichtigen, daß geätzte Näpfchen, die flacher und weniger tief sind als gravierte spitze Näpfchen, sich auch besser entleeren lassen. Somit ist die Verwendung geätzter Näpfchen bei der Verdruckung strahlungshärtender Druckfarben ohne flüchtige Bestandteile von Vorteil.

Nach einem anderen vorteilhaften Merkmal wird vorgeschlagen, daß die Druckfarbe als Photoinitiator für die Initiierung der radikalischen Polymerisation eine oder mehrere folgender Verbindungen enthält: 2-Benzyl-2-dimethylamino-1-(4morpholinophenyl)-butanone-1, Phoshinoxide, insbesondere 2,4,6-Trimethylbenzoyldiphenylphosphinoxid, 2,4,6-Trimethylbenzoylphenyläthoxyphosphinoxid, Bis(2,4,6-trimetylbenzoyl)-phenylphosphinoxid, Bis(2,6-dimethoxybenzoyl)-2,4,4-trimethyl-pentylphosphinoxid 1-Hydroxy-cyclohexyl-phenyl-keton, 1-[4-(2-Hydroxyethoxy)phenyl]-2-hydroxy-2-methyl-1-Propan-1-on, 2-Hydroxy-2-methyl-1-phenylpropan-1-on, 1-Hydroxy-cyclohexyl-phenyl-keton, 1-(4-Isopropylphenyl)-2-hydroxy-2-methyl-propan-1-on, 2-Methyl-1-[4-(methylthio)phenyl]-2-morhpolinopropanon-(1) oder Thioxanthonderivate, insbesondere 2-Isopropylthioxanthon. Nach einem zusätzlichen vorteilhaften Merkmal kann vorgesehen sein, daß die Druckfarbe Derivate unter Einsatz von Coinitiatoren, insbesondere Amine enthält.

Mit den nachstehenden Beispielen von erfindungsgemäß zusammengesetzten Formulierungen und deren Anwendung soll die erfinderische Lehre zum technischen Handeln verdeutlicht werden.

Das erfindungsgemäße Verfahren für den Rotationstiefdruck mit radikalisch polymerisierbaren Druckfarben läßt sich kurz zusammengefaßt so beschreiben, daß die Druckfarben, die durch aktinische Strahlung gehärtet werden, abgesehen von notwendigen Additiven und Pigmenten keine organischen Lösungsmittel und kein Wasser als Verdünnungsmittel oder Fließmittel enthalten. Die erforderliche Fließfähigkeit der Farben für den Rotationstiefdruck wird, neben der Verwendung üblicher Reaktivverdünner wie polymerisierbarer Acrylate, durch den Einsatz polymerisierbarer Vinyläther bzw. Hydroxylvinyläther erreicht.

Ein typisches erfindungsgemäßes strahlungshärtbares Farbsystem für den Tiefdruck, das die Anforderungen hinsichtlich niedriger Viskosität und hoher Druckgeschwindigkeit erfüllt, hat die in der nachfolgenden Tabelle 1 aufgeführte Zusammensetzung.

Tabelle 1.

| Prinzipielle Zusammensetzung einer strahlungshärtenden UV-Tiefdruckfarbe. | |
|---|---|
| **Bestandteil** | **Anteil** |
| Bindemittel aus präpolymeren oder oligomeren Acrylsäureestern (MG < 1500) | 20 - 75% |
| Bindemittel aus präpolymeren oder oligomeren Acrylsäureestern (MG > 1500) | 0 - 10% |
| Monomerer Reaktivverdünner aus Acrylsäureester | 0 - 75% |
| Reaktivverdünner auf Basis eines Vinyläthers | 4 - 20% |
| Pigmente | 0 - 45% |
| Photoinitiatoren | 2 - 15% |
| Additive (Entschäumer, Netzmittel u.a) | 1 - 10% |

Beispiel 1

Eine strahlenhärtende blaue Tiefdruckfarbe ist beispielsweise gemäß der nachfolgenden Tabelle 2 zusammengesetzt.

Tabelle 2.

| Strahlenhärtende blaue Tiefdruckfarbe. | | |
|---|---|---|
| Komponente | | Anteil |
| Laromer LR 8869 | 7) | 61,9% |
| Heliogenblau DD 7084DD | 7) | 18,2% |
| Irgacure 369 | 4) | 1,5% |
| Quantacure ITX (2-Isopropylthioxanthon) | | 3% |
| Irgacure 907 | 4) | 2,4% |
| Flourstab UV 1 | 8) | 0,6% |
| Triäthylenglycoldivinyläther (DVE-3) | | 10% |
| Solsperse 32000 | 3) | 2,4% |

Beispiel 2

Ein Beispiel einer strahlenhärtenden weißen Tiefdruckfarbe zeigt Tabelle 3.

Tabelle 3.

| Strahlenhärtende weiße Tiefdruckfarbe. | | |
|---|---|---|
| Komponente | | Anteil |
| Actilane 440 | 9) | 20% |
| Ebecryl PETIA | 1) | 20% |
| Rapicure (DVE-3) | 5) | 12,5% |
| Titandioxyd | | 40% |
| Darocure 4265 | 4) | 7% |
| Solsperse 26000 | 3) | 0,5% |

Beispiel 3

Den Einfluß von Triäthylenglycoldivinyläther (DVE-3) und der Temperatur auf die gemessene Viskosität in mPas der Formulierung aus Beispiel 1 zeigt Tabelle 4.

Tabelle 4.

| Einfluß von DVE-3 und Temperatur auf die Viskosität. | | | | |
|---|---|---|---|---|
| Temperatur | 25°C | 30°C | 35°C | 40°C |
| ohne DVE-3 | 360 mPas | 278 mPas | 208 mPas | 160 mPas |
| mit 10% DVE-3 | 178 mPas | 139 mPas | 109 mPas | 86 mPas |

Beispiele 4 bis 9

Die Tabelle 5 zeigt verschiedene Formulierungen strahlenhärtender Tiefdruckfarben und ihre Viskosität bei 23 °C und D=4600 sec$^{-1}$ in mPas.

Tabelle 5.

| Erfindungsgemäße Druckfarben. | | | | | | |
|---|---|---|---|---|---|---|
| | Beispiel Nr. | | | | | |
| Komponente | 4 | 5 | 6 | 7 | 8 | 9 |
| Craynor CN 922          6) | 15,5 % | 14 % | 15,5 % | 14,5 % | 14,5 % | 14,6 % |
| Ethoxyliertes Pentaerythrioltetra-acrylat (PPTTA) | - | 14 % | 15,6 % | - | 14,6 % | 14,6 % |
| Pentaerythioltri-acrylat (PETIA) | - | - | - | - | 14,5 % | - |
| Ebecryl 81          1) | 9,3 % | 14 % | 15,5 % | 8,7 % | - | 14,5 % |
| Genomer 3364          2) | 21,8 % | - | - | 20,4 % | - | - |
| 1,6-Hexandiacrylsäureäthylester (HDDA) | - | 4,6 % | - | - | - | - |
| Triäthylenglycoldivinyläther (DVE-3) | 11% | 11% | 11% | 11% | 11% | 11% |
| Solsperse 26000          3) | 0,4% | 0,4% | 0,4% | 0,4% | 0,4% | 0,4% |
| Darocure 4265          4) | 7% | 7% | 7% | 7% | 7% | 7% |
| Speedcure DMB          2) | - | - | - | 3% | 3% | 3% |
| Titandioxid A 1071 | 35% | 35% | 35% | 35% | 35% | 35% |
| Viskosität [η] D= 4600 sec⁻¹ | 140 mPas | 100 mPas | 130 mPas | 120 mPas | 160 mPas | 110 mPas |

Tabelle 5a.

| Herstellerangaben in den Tabellen 2, 3 und 5 | |
|---|---|
| 1) | UCB-Chemicals |
| 2) | Rahn (Zürich) |
| 3) | Avecia |
| 4) | Ciba Spezialitätenchemie |
| 5) | ISP |
| 6) | Cray Valley |
| 7) | BASF AG |
| 8) | Kromachem |
| 9) | Akzo Resins |

Beispiel 10

Die UV-Tiefdruckfarbe gemäß Beispiel 1 wurde mit folgender Druckwerkkonfiguration verdruckt: In einer Farbwanne rotiert eine Gummiwalze, deren Oberfläche ständig mit der UV-Tiefdruckfarbe benetzt wird. Die Gummiwalze drückt mitläufig gegen eine Tiefdruck-Rasterwalze. Die Rasterung hat vier Bereiche mit 100, 120, 140 und 165 Linien/cm und 11 abgestufte Flächendeckungen von licht bis Vollton und mit den in der Tabelle angegebenen Näpfchentiefen. Die Näpfchen haben die Form umgekehrter Pyramiden. Die Grundfläche ist ca. 80x80 µm bei 100 Linien/cm Vollton und 40x40 µm bei 165 Linien Vollton. Einzelheiten sind in Tabelle 6 dargestellt.

Tabelle 6.

| Tiefdruckzylinderdaten. | | | |
|---|---|---|---|
| Raster (Linien/ cm) | Näpfchen Vollton (µm) | Näpfchen Mittelton (µm) | Näpfchen licht (µm) |
| 100 | 26 | 16 | 6 |
| 120 | 22 | 14 | 6 |
| 140 | 18 | 12 | 6 |
| 165 | 16 | 10 | 6 |

Die überschüssige Farbe wird von der Rasterwalze abgerakelt. Danach erfolgt die Übertragung des Druckbildes auf das Substrat. Als Substrat wurde Polyethylenfolie verwendet.

Die Druckgeschwindigkeit betrug 100 m/min. Bei dieser Geschwindigkeit konnten alle Farbbereiche (Farbdichten zwischen 2,1 und 1,5 je nach Rasterung) mit einem 308 nm Excimer-Doppellampensystem unter Inertgas (Stickstoff) einwandfrei gehärtet werden. Die Geometrie der Druckpunkte betrug für Vollton bei 165 Linien/cm Rasterung im Mittel 53x45 µm (Näpfchen-Grundriß 40x40 µm). Die Charakterisierung der Trocknung der UV-Tiefdruckfarbe erfolgte durch Bestimmung migrierbarer Bestandteile (Rest-Photoinitiator, Restmonomere) unter folgenden Bedingungen: Es wurden Drucke mit Farbdichte 2 ausgewählt und in Acetonitril 10 min im Ultraschallbad extrahiert, danach mittels HPLC analysiert. Gefunden wurden: Restmonomere = 0,22 mg/dm$^2$, Summe Photoinitiator bzw. Photoinitiator-Abbauprodukte 0,43 mg/dm$^2$.

Beispiel 11

Die UV- Tiefdruckfarbe aus Beispiel 1 wurde mit folgender Druckwerkkonfiguration verdruckt: Ein Druckkammerrakel sitzt auf der Tiefdruckwalze und dient zur Zwangsbefüllung der Tiefdruck-Rasterwalze. Die Rasterung der Tiefdruckwalze ist wie in Tabelle 6 angegeben. Die überschüssige Farbe wird von der Rasterwalze abgerakelt. Danach erfolgt die Übertragung des Druckbildes auf das Substrat. Als Substrat wurde Polyethylenfolie verwendet. Die Druckgeschwindigkeit betrug 100 m/min. Bei dieser Geschwindigkeit konnten alle Farbbereiche (Farbdichten zwischen 2,0 und 1,5 je nach Rasterung) mit einem 308 nm Excimer-Doppellampensystem unter Inertgas (Stickstoff) einwandfrei gehärtet werden.

Die Geometrie der Druckpunkte betrug für Vollton bei 165 Linien/cm Rasterung im Mittel 55x48 µm (Näpfchen-Grundriß 40x40 µm). Die Charakterisierung der Trocknung der UV-Tiefdruckfarbe erfolgte durch Bestimmung migrierbarer Bestandteile (Rest-Photoinitiator, Restmonomere). Gefunden wurden: Restmonomere = 0,20 mg/dm$^2$, Summe Photoinitiator bzw. Photoinitiator-Abbauprodukte 0,51 mg/dm$^2$.

Beispiel 12

Die UV-Tiefdruckfarbe aus Beispiel 2 wurde auf einer Druckmaschine M3300 - Multi (Nilpeter) mit Tiefdruckwerk bei einer Temperatur von 35 °C und einem Gravurzylinder (70-er Gravur; Stichelwinkel 120 °C) verdruckt, wobei sowohl ein gestauchter Raster mit 33 µm Gravurtiefe wie auch ein feiner Raster mit 26 µm Tiefe verwendet wurden. Gedruckt wurde auf einem LDPE/oPA-Laminat und zwar auf der LDPE-Seite, und auf einer oPP-Folie. Vor dem Druck erfolgte in beiden Fällen eine Coronavorbehandlung,. Gedruckt wurde mit einer Geschwindigkeit von 40 m/min. Nach dem Druck erfolgte die UV-Härtung mit einem UV-Strahler (Leistung 120 W/cm).

Die erhaltenen Drucke hatten im Vollton eine gute Qualität und hafteten auf den Folien.

**Patentansprüche**

1.   Rotationstiefdruckverfahren zum Bedrucken von Substraten, bei dem eine durch aktinische Strahlung härtbare Druckfarbe verdruckt wird, wobei die Druckfarbe mittels eines gravierten oder geätzten Tiefdruckzylinders, dessen für die Farbaufnahme vorgesehene Näpfchen dem jeweils gewünschten Druckbild angepaßt sind, auf ein zu bedruckendes Substrat aufgetragen wird und der Druckfarbenfilm anschließend durch aktinische Strahlung unter Polymerisation des Bindemittels der Druckfarbe gehärtet wird,
wobei die Druckfarbe 20 - 75 Gew.-%, vorzugsweise 30 - 70 Gew.-% eines durch aktinische Strahlung härtbaren Bindemittelsystems, 2 - 25 Gew.-%, vorzugsweise 4 - 15 Gew.-% eines Vinyläthers, 0 - 45 Gew.-% eines Farbmittels, 2 - 15 Gew.-%, vorzugsweise 2 - 10 Gew.-% eines radikalischen Photoinitiators und 0 - 10 Gew.-% Additive enthält,

**dadurch gekennzeichnet, daß**

die Viskosität der strahlungshärtbaren Druckfarbe bei 20 °C und einem Schergefälle von D=100 sec$^{-1}$ kleiner als 305 mPas ist und die Viskosität durch Erwärmung des Druckzylinders bis auf 50 °C auf einen Wert unter 100 mPas (D=100 sec$^{-1}$) reduziert wird und

die Druckfarbe als Additiv zur Verbesserung der Haftung auf Kunststoff- oder Metallfolien Silane mit einem Anteil zwischen 0,5 und 5 Gew.-%, vorzugsweise 1-3 Gew.-%, enthält.

**2.** Verfahren nach Anspruch 1, **dadurch gekennzeichnet, daß** die Druckfarbe einen Anteil von 20 - 75 Gew.-% niedermolekularer Bindemittel aus präpolymeren oder oligomeren Acrylsäureestern mit einem Molekulargewicht unter 1500 enthält.

**3.** Verfahren nach Anspruch 1 oder 2, **dadurch gekennzeichnet, daß** die Druckfarbe einen Anteil von 0 - 10 Gew.-% hochmolekularer Bindemittel aus präpolymeren oder oligomeren Acrylsäureestern mit einem Molekulargewicht über 1500 enthält.

**4.** Verfahren nach einem der vorhergehenden Ansprüche, **dadurch gekennzeichnet, daß** die Druckfarbe einen Anteil von 0 - 75 Gew.-% eines monomeren Reaktivverdünners aus Acrylsäureester enthält.

**5.** Verfahren nach einem der vorhergehenden Ansprüche, **dadurch gekennzeichnet, daß** die Strahlungshärtung in inerter Atmosphäre, insbesondere unter Stickstoffoder Kohlendioxidatmosphäre durchgeführt wird.

**6.** Verfahren nach einem der vorhergehenden Ansprüche, **dadurch gekennzeichnet, daß** die Druckfarbe als niedermolekulares Bindemittel ein oder mehrere Polyesteracrylate, Polyätheracrylate einschließlich aminomodifizierter Typen oder Urethanacrylate mit einem Molekulargewicht kleiner 1500 und einer Acrylatfunktionalität von mindestens 2, vorzugweise 3 bis 4 enthält.

**7.** Verfahren nach einem der vorhergehenden Ansprüche, **dadurch gekennzeichnet, daß** die Druckfarbe ein Polyester- oder ein Polyätheracrylat einschließlich einer aminomodifizierten Type, ein Epoxyacrylat oder ein Polyurethanacrylat mit einem Molekulargewicht größer als 1500 und einer Acrylatfunktionalität von mindestens 2, vorzugsweise 3 bis 4 enthält, wobei deren Anteil maximal 10 Gew.-% an der Summe aus Bindemitteln und Pigment beträgt.

**8.** Verfahren nach einem der vorhergehenden Ansprüche, **dadurch gekennzeichnet, daß** das Bindemittel der Druckfarbe eines oder mehrerer folgender Monomere enthält: HDDA, Di- oder Tripropylenglycoldiacrylat (DPGDA,TPGDA), Trimethylolpropan- di-oder Triacrylat (TMPDA,TMPTA) einschließlich deren ethoxyliete bzw. propoxylierte Abkömmlinge, Pentaerythrioltriacrylat (PETIA), bzw. Pentaerythrioltetraacrylat (PETTA) einschließlich deren ethoxyliete bzw. propoxylierte Derivate (wie z.B. PPTTA), Ditrimethylolpropantetraacrylat (DiTMPTTA), Tris(2-Hydroxyethyl)isocyanurattriacrylat (THEICTA) und triacryliertes Glycerol (GPTA).

**9.** Verfahren nach einem der vorhergehenden Ansprüche, **dadurch gekennzeichnet, daß** die Druckfarbe als Vinyläther im wesentlichen di- oder höherfunktionelle Vinyläther, insbesondere Butandioldivinyläther (BDDVE), Diäthylenglycoldivinyläther (DVE-2), Triäthylenglycoldivinyläther (DVE-3), Cyclohexandimethanoldivinyläther (CHDVE), Hexandioldivinyläther (HDDVE), Diisopropylglycoldivinyläther (DPE-2), Triisopropylglycoldivinyläther (DPE-3) oder Trimethylolpropantrivinyäther (TMPTVE) enthält.

**10.** Verfahren nach einem der vorhergehenden Ansprüche, **dadurch gekennzeichnet, daß** die Druckfarbe als Vinyläther monomere Vinyläther oder Hydroxyvinyläther, insbesondere 2-Ethylhexylvinyläther (EHVE), Octadecylvinyläther (ODVE), Cyclohexylvinyläther (CVE), Cyclohexandimethanolmonovinyläther (CHMVE), Dodeclvinyläther (DDVE) oder Diäthylenglycolmonovinyläther (MVE-2) enthält.

**11.** Verfahren nach einem der vorhergehenden Ansprüche, **dadurch gekennzeichnet, daß** die Druckfarbe eines oder mehrere folgender Silane enthält: 3-Aminopropyltrimethoxysilan, 3-Aminopropyl-triethoxysilan, N-(n-Butyl)-3-aminopropyltrimethoxysilan, polyglykolethermodifiziertes Aminosilan, N-Aminoethyl-3-aminopropylmethyldimethoxysilan, 3-Aminopropylmethyl-diethoxysilan, 3-Ureidopropyltriethoxysilan, N-Aminoethyl-3-aminopropyltrimethoxysilan, triaminofunktionelles Propyltrimethoxysilan, 3-(4,5-Dihydroimidazolyl)-propyltriethoxysilan, 3-Methacryloxypropyltrimethoxysilan, 3-Glycidyloxypropyltrimethoxysilan, 3-Glycidyloxypropyltriethoxysilan, 3-Mercaptopropyltrimethoxysilan, Polyethersilan, Vinyltrichlorsilan, Vinyltrimethoxysilan, Vinyltriethoxysilan, Vinyltris(2-methoxyethoxy)silan.

**12.** Verfahren nach einem der vorhergehenden Ansprüche, **dadurch gekennzeichnet, daß** die Druckfarbe als Photoinitiator für die Initiierung der radikalischen Polymerisation eine oder mehrere folgender Verbindungen enthält: 2-Benzyl-2-dimethylamino-1-(4morpholinophenyl)-butanone-1, Phosphinoxide, insbesondere 2,4,6-Trimethylbenzoyldiphenylphosphinoxid, 2,4,6-Trimethylbenzoylphenyläthoxyphosphinoxid, Bis(2,4,6-trimetylbenzoyl)-phenylphosphinoxid, Bis(2,6-dimethoxybenzoyl)-2,4,4-trimethyl-pentylphosphinoxid 1-Hydroxycyclohexylphenylketon, 1-[4-(2-Hydroxyethoxy)phenyl]-2-hydroxy-2-methyl-1-Propan-1-on, 2-Hydroxy-2-methyl-1-phenylpropan-1-on, 1-Hydroxy-cyclohexylphenylketon, 1-(4-Isopropylphenyl)-2-hydroxy-2-methylpropan-1-on, 2-Methyl-1-[4-(methylthio)phenyl]-2-morhpolinopropanon-(1) oder Thioxanthonderivate, insbesondere 2-Isopropylthioxanthon.

**13.** Verfahren nach Anspruch 12, **dadurch gekennzeichnet, daß** die Druckfarbe Coinitiatoren, insbesondere Amine enthält.

**14.** Tiefdruckfarbe zur Verwendung in einem Rotationstiefdruckverfahren, wobei die Druckfarbe durch aktinische Strahlung unter Polymerisation ihres Bindemittels härtbar ist und 20 - 75 Gew.-%, vorzugsweise 30 - 70 Gew.-% eines durch aktinische Strahlung härtbaren Bindemittelsystems, 2 - 25 Gew.-%, vorzugsweise 4 - 15 Gew.-% eines Vinyläthers, 0 - 45 Gew.-% eines Farbmittels, 2 - 15 Gew.-%, vorzugsweise 2 - 10 Gew.-% eines radikalischen Photoinitiators und 0 - 10 Gew.-% Additive enthält, **dadurch gekennzeichnet, daß** die Viskosität der strahlungshärtbaren Druckfarbe bei 20 °C und einem Schergefälle von D=100 sec$^{-1}$ kleiner als 305 mPas ist und die Viskosität durch Erwärmung des Druckzylinders bis auf 50 °C auf einen Wert unter 100 mPas (D=100 sec$^{-1}$) reduzierbar ist und die Druckfarbe als Additiv zur Verbesserung der Haftung auf Kunststoff- oder Metallfolien Silane mit einem Anteil zwischen 0,5 und 5 Gew.-%, vorzugsweise 1-3 Gew.-%, enthält.

**15.** Tiefdruckfarbe nach Anspruch 14, **dadurch gekennzeichnet, daß** die Druckfarbe als Photoinitiator für die Initiierung der radikalischen Polymerisation eine oder mehrere folgender Verbindungen enthält: 2-Benzyl-2-dimethylamino-1-(4morpholinophenyl)-butanone-1, 2,4,6-Trimethylbenzoylphenyläthoxyphosphinoxid, 1-[4-(2-Hydroxyethoxy)-phenyl]-2-hydroxy-2-methyl-1-Propan-1-on.

**16.** Tiefdruckfarbe nach einem der Ansprüche 14 bis 15, **dadurch gekennzeichnet, daß** die Druckfarbe als niedermolekulares Bindemittel ein oder mehrere Polyesteracrylate, Polyätheracrylate einschließlich aminomodifizierter Typen oder Urethanacrylate mit einem Molekulargewicht kleiner 1500 und einer Acrylatfunktionalität von mindestens 2, vorzugweise 3 bis 4 enthält.

**17.** Tiefdruckfarbe nach einem der Ansprüche 14 bis 16, **dadurch gekennzeichnet, daß** das Bindemittel der Druckfarbe eines oder mehrerer folgender Monomere enthält: Pentaerythrioltriacrylat (PETIA) einschließlich dessen ethoxylierte bzw. propoxylierte Derivate (wie z.B. PPTTA), Tris(2-Hydroxyethyl)isocyanurattriacrylat (THEICTA).

**18.** Tiefdruckfarbe nach einem der Ansprüche 14 bis 17, **dadurch gekennzeichnet, daß** die Druckfarbe als Photoinitiator für die Initiierung der radikalischen Polymerisation eine oder mehrere folgender Verbindungen enthält: Phosphinoxide, insbesondere Bis(2,4,6-trimetylbenzoyl)-phenylphosphinoxid, Bis(2,6-dimethoxybenzoyl)-2,4,4-trimethyl-pentylphosphinoxid 1-Hydroxycyclohexylphenylketon, 2-Hydroxy-2-methyl-1-phenylpropan-1-on, 1-(4-Isopropylphenyl)-2-hydroxy-2-methylpropan-1-on oder Thioxanthonderivate.

**19.** Tiefdruckfarbe nach einem der Ansprüche 14 bis 18, **dadurch gekennzeichnet, daß** sie Merkmale nach einem der Ansprüche 1 bis 13 umfaßt.

**20.** Substrat, **dadurch gekennzeichnet, daß** es mit einem Druckverfahren nach einem der Ansprüche 1 bis 13 und/ oder einer Druckfarbe nach einem der Ansprüche 14 bis 19 bedruckt ist.

**Claims**

**1.** Rotogravure printing method for the printing on substrates, in which method an actinic radiation-curable printing ink is used, whereby the printing ink is applied to a printing substrate by means of an engraved or etched gravure printing cylinder whose gravure cells for the uptake of printing ink are adapted to the printing image desired in the individual case, and the printing ink film is subsequently cured by actinic radiation under polymerization of the binding agent of the printing ink,

whereby the printing ink contains 20-75 % (w/w), preferably 30-70 % (w/w), of an actinic radiation-curable binding agent system, 2-25 % (w/w), preferably 4-15 % (w/w), of a vinyl ether, 0-45 % (w/w) of a coloring agent, 2-15 % (w/w), preferably 2-10 % (w/w), of a radical photoinitiator, and 0-10 % (w/w) additives,

**characterized in that**

the viscosity of the radiation-curable printing ink at 20 °C and a shear rate of D=100 sec$^{-1}$ is less than 305 mPas, and the viscosity is reduced to a value of less than 100 mPas (D=100 sec$^{-1}$) by tempering the printing cylinder up to 50 °C, and

the printing ink contains silanes at a fraction between 0.5 and 5 % (w/w), preferably 1-3 % (w/w), as an additive to improve the adherence to plastic films or metal foils.

2. Method according to claim 1, **characterized in that** the printing ink contains a fraction of 20-75 % (w/w) of low molecular weight binding agents made of prepolymeric or oligomeric acrylic acid esters with a molecular weight of less than 1500.

3. Method according to claim 1 or 2, **characterized in that** the printing ink contains a fraction of 0-10 % (w/w) of high molecular weight binding agents made of prepolymeric or oligomeric acrylic acid esters with a molecular weight above 1500.

4. Method according to any one of the preceding claims, **characterized in that** the printing ink contains a fraction of 0-75 % (w/w) of a monomeric reactive diluent made of acrylic acid ester.

5. Method according to any one of the preceding claims, **characterized in that** the radiation curing is performed in an inert atmosphere, in particular under a nitrogen or carbon dioxide atmosphere.

6. Method according to any one of the preceding claims, **characterized in that** the printing ink contains as low molecular weight binding agent one or several polyester acrylates, polyether acrylates including amino-modified types, or urethane acrylates with a molecular weight of less than 1500 and an acrylate functionality of at least 2, preferably 3 to 4.

7. Method according to any one of the preceding claims, **characterized in that** the printing ink contains a polyester acrylate or a polyether acrylate including an amino-modified type thereof, an epoxy acrylate or a polyurethane acrylate with a molecular weight above 1500 and an acrylate functionality of at least 2, preferably 3 to 4, whereby the fraction of these substances accounts for max. 10 % (w/w) of the sum of binding agent and pigment.

8. Method according to any one of the preceding claims, **characterized in that** the binding agent of the printing ink contains one or several of the following monomers: HDDA, di- or tripropyleneglycol diacrylate (DPGDA,TPGDA), trimethylolpropane di- or triacrylate (TMPDA,TMPTA) including their ethoxylated or propoxylated derivatives, pentaerythriol triacrylate (PETIA) or pentaerythriol tetraacrylate (PETTA) including their ethoxylated or propoxylated derivatives (such as PPTTA), ditrimethylolpropane tetraacrylate (DiTMPTTA), tris(2-hydroxyethyl)-isocyanurate triacrylate (THEICTA) and triacrylated glycerol (GPTA).

9. Method according to any one of the preceding claims, **characterized in that** the printing ink contains as vinyl ether essentially di-vinyl ethers and vinyl ethers of higher functionality, in particular butanediol divinyl ether (BDDVE), diethyleneglycol divinyl ether (DVE-2), triethyleneglycol divinyl ether (DVE-3), cyclohexanedimethanol divinyl ether (CHDVE), hexanediol divinyl ether (HDDVE), diisopropylglycol divinyl ether (DPE-2), triisopropylglycol divinyl ether (DPE-3) or trimethylolpropane trivinyl ether (TMPTVE).

10. Method according to any one of the preceding claims, **characterized in that** the printing ink contains as vinyl ether monomeric vinyl ethers or hydroxyvinyl ethers, in particular 2-ethylhexyl vinyl ether (EHVE), octadecyl vinyl ether (ODVE), cyclohexyl vinyl ether (CVE), cyclohexanedimethanol monovinyl ether (CHMVE), dodecyl vinyl ether (DDVE) or diethyleneglycol monovinyl ether (MVE-2).

11. Method according to any one of the preceding claims, **characterized in that** the printing ink contains one or several of the following silanes: 3-aminopropyltrimethoxysilane, 3-aminopropyltriethoxysilane, N-(n-butyl)-3-aminopropyltrimethoxysilane, polyglycolether-modified aminosilane, N-aminoethyl-3-aminopropylmethyldimethoxysilane, 3-aminopropylmethyl-diethoxysilane, 3-ureidopropyltriethoxysilane, N-aminoethyl-3-aminopropyltrimethoxysilane, triamino-functional propyltrimethoxysilane, 3-(4,5-dihydroimidazolyl)-propyltriethoxysilane, 3-methacryloxypropyltrimethoxysilane, 3-glycidyloxypropyltrimethoxysilane, 3-glycidyloxypropyltriethoxysilane, 3-mercaptopropyltrimethoxysilane, polyethersilane, vinyltrichlorosilane, vinyltrimethoxysilane, vinyltriethoxysilane, vinyltris (2-methoxyethoxy)silane.

12. Method according to any one of the preceding claims, **characterized in that** the printing ink contains as a photoinitiator for the initiation of the radical polymerization one or several of the following compounds: 2-benzyl-2-dimethylamino-1-(4-morpholinophenyl)-butanone-1, phoshine oxides, in particular 2,4,6-trimethylbenzoyldiphenyl phosphine oxide, 2,4,6-trimethylbenzoylphenylethoxy phosphine oxide, bis(2,4,6-trimethylbenzoyl)-phenyl phosphine oxide, bis(2,6-dimethoxybenzoyl)-2,4,4-trimethylpentyl phosphine oxide, 1-hydroxycyclohexylphenylketone, 1-[4-(2-hydroxyethoxy)-phenyl]-2-hydroxy-2-methyl-1-propan-1-one, 2-hydroxy-2-methyl-1-phenylpropan-1-one, 1-hydroxycyclohexylphenylketone, 1-(4-isopropylphenyl)-2-hydroxy-2-methylpropan-1-one, 2-methyl-1-[4-(methylthio)phenyl]-2-morpholinopropanone-(1) or thioxanthone derivatives, in particular 2-isopropyl thioxanthone.

13. Method according to claim 12, **characterized in that** the printing ink contains coinitiators, in particular amines.

14. Gravure printing ink for use in a rotogravure printing process, whereby the printing ink is curable by actinic radiation under polymerization of its binding agent and contains 20-75 % (w/w), preferably 30-70 % (w/w), of an actinic radiation-curable binding agent system, 2-25 % (w/w), preferably 4-15 % (w/w), of a vinyl ether, 0-45 % (w/w) of a coloring agent, 2-15 % (w/w), preferably 2-10 % (w/w), of a radical photoinitiator, and 0-10 % (w/w) additives, **characterized in that** the viscosity of the radiation-curable printing ink at 20 °C and a shear rate of D=100 sec$^{-1}$ is less than 305 mPas, and the viscosity may be reduced to a value of less than 100 mPas (D=100 sec$^{-1}$) by tempering the printing cylinder up to 50 °C, and the printing ink contains silanes at a fraction between 0.5 and 5 % (w/w), preferably 1-3 % (w/w), as an additive to improve the adherence to plastic films or metal foils.

15. Gravure printing ink according to claim 14, **characterized in that** the printing ink contains as a photoinitiator for the initiation of the radical polymerization one or several of the following compounds: 2-benzyl-2-dimethylamino-1-(4-morpholinophenyl)-butanone-1, 2,4,6-trimethylbenzoylphenylethoxy phosphine oxide, 1-[4-(2-hydroxyethoxy)-phenyl]-2-hydroxy-2-methyl-1-propan-1-one.

16. Gravure printing ink according to claim 14 or 15, **characterized in that** the printing ink contains as low molecular weight binding agent one or several polyester acrylates, polyether acrylates including amino-modified types, or urethane acrylates with a molecular weight of less than 1500 and an acrylate functionality of at least 2, preferably 3 to 4.

17. Gravure printing ink according to claim 14 or 16, **characterized in that** the binding agent of the printing ink contains one or several of the following monomers: pentaerythriol triacrylate (PETIA) including its ethoxylated or propoxylated derivatives (such as PPTTA), tris(2-hydroxyethyl)-isocyanurate triacrylate (THEICTA).

18. Gravure printing ink according to any one of the claims 14 to 17, **characterized in that** the printing ink contains as a photoinitiator for the initiation of the radical polymerization one or several of the following compounds: phosphine oxides, in particular bis(2,4,6-trimethylbenzoyl)-phenyl phosphine oxide, bis(2,6-dimethoxybenzoyl)-2,4,4-trimethyl-pentyl phosphine oxide, 1-hydroxycyclohexylphenylketone, 2-hydroxy-2-methyl-1-phenylpropan-1-one, 1-(4-isopropylphenyl)-2-hydroxy-2-methylpropan-1-one or thioxanthone derivates.

19. Gravure printing ink according to any one of the claims 14 to 18, **characterized in that** it comprises features according to any one of the claims 1 to 13.

20. Substrate **characterized in that** it is printed on by means of a printing method according to any one of the claims 1 to 13 and/or with a printing ink according to any one of the claims 14 to 19.

**Revendications**

1. Procédé d'héliogravure rotative pour imprimer des substrats, dans lequel on imprime une encre d'imprimerie durcissable sous l'effet d'un rayonnement actinique, dans lequel l'encre d'imprimerie est appliquée sur un substrat à imprimer au moyen d'un cylindre d'héliogravure gravé ou corrodé, dont des godets prévus pour la réception d'encre sont adaptés au motif d'impression respectivement souhaité, et ensuite, le film d'encre d'imprimerie est durci au moyen d'un rayonnement actinique avec polymérisation du liant de l'encre d'imprimerie,

dans lequel l'encre d'imprimerie contient 20 - 75 % en poids, de préférence 30 - 70 % en poids d'un système de liant durcissable par rayonnement actinique, 2 - 25 % en poids, de préférence 4 - 15 % en poids d'un éther de vinyle, 0 - 45 % en poids d'un colorant, 2 - 15 % en poids, de préférence 2 - 10 % en poids d'un photo-initiateur radicalaire et 0 - 10 % en poids d'additifs,

**caractérisé en ce que**

la viscosité de l'encre d'imprimerie durcissable par rayonnement à 20°C et à un gradient de cisaillement de D = 100 s$^{-1}$ est inférieure à 300 mPas et la viscosité est réduite à une valeur inférieure à 100 mPas (D = 100 s$^{-1}$) par chauffage du cylindre d'impression jusqu'à 50°C, et

l'encre d'imprimerie contient, comme additif pour améliorer l'adhérence sur des feuilles de matière plastique ou de métal, des silanes dans une proportion comprise entre 0,5 et 5 % en poids, de préférence 1-3 % en poids.

2. Procédé selon la revendication 1, **caractérisé en ce que** l'encre d'imprimerie contient une proportion de 20 - 75 % en poids de liants de poids moléculaire bas à base de prépolymères ou d'oligomères d'esters de l'acide acrylique ayant un poids moléculaire inférieur à 1500.

3. Procédé selon la revendication 1 ou 2, **caractérisé en ce que** l'encre d'imprimerie contient une proportion de 0 - 10 % en poids de liants de poids moléculaire élevé à base de prépolymères ou d'oligomères d'esters de l'acide acrylique ayant un poids moléculaire supérieur à 1500.

4. Procédé selon l'une des revendications précédentes, **caractérisé en ce que** l'encre d'imprimerie contient une proportion de 0 - 75 % en poids d'un diluant réactif monomère à base d'ester de l'acide acrylique.

5. Procédé selon l'une des revendications précédentes, **caractérisé en ce qu'**on effectue le durcissement par rayonnement dans une atmosphère inerte, en particulier dans une atmosphère d'azote ou de dioxyde de carbone.

6. Procédé selon l'une des revendications précédentes, **caractérisé en ce que** l'encre d'imprimerie contient, en tant que liant de poids moléculaire bas, un ou plusieurs acrylates de polyester, acrylates de polyéther, y compris des types à modification amino, ou des acrylates d'uréthanne ayant un poids moléculaire inférieur à 1500 et une fonctionnalité acrylate d'au moins 2, de préférence de 3 à 4.

7. Procédé selon l'une des revendications précédentes, **caractérisé en ce que** l'encre d'imprimerie contient un acrylate de polyester ou un acrylate de polyéther, y compris d'un type à modification amino, un acrylate d'époxy ou un acrylate de polyuréthanne ayant un poids moléculaire supérieur à 1500 et une fonctionnalité acrylate d'au moins 2, de préférence de 3 à 4, dont la proportion est au maximum de 10 % en poids par rapport à la somme des liants et du pigment.

8. Procédé selon l'une des revendications précédentes, **caractérisé en ce que** le liant de l'encre d'imprimerie contient un ou plusieurs des monomères suivants : HDDA, diacrylate de di- ou tripropylèneglycol (DPGDA, TPGDA), di- ou triacrylate de triméthylolpropane (TMPDA, TMPTA), y compris leurs dérivés éthoxylés ou propoxylés, triacrylate de pentaérythritol (PETIA) et/ou tétraacrylate de pentaérythritol (PETTA), y compris leurs dérivés éthoxylés ou propoxylés (comme par exemple PPTTA), tétraacrylate de ditriméthylolpropane (DiTMPTTA), triacrylate d'isocyanurate de tris(2-hydroxyéthyle) (THEICTA) et glycérol triacrylé (GPTA) .

9. Procédé selon l'une des revendications précédentes, **caractérisé en ce que** l'encre d'imprimerie contient, comme éther de vinyle, un éther de vinyle essentiellement bifonctionnel ou de fonctionnalité supérieure, en particulier éther divinylique de butanediol (BDDVE), éther divinylique de diéthylèneglycol (DVE-2), éther divinylique de triéthylèneglycol (DVE-3), éther divinylique de cyclohexanediméthanol (CHDVE), éther divinylique d'hexanediol (HDDVE), éther divinylique de diisopropylglycol (DPE-2), éther divinylique de triisopropylglycol (DPE-3) ou éther trivinylique de triméthylolpropane (TMPTVE).

10. Procédé selon l'une des revendications précédentes, **caractérisé en ce que** l'encre d'imprimerie contient, en tant qu'éther de vinyle, des éthers de vinyle monomères ou des éthers hydroxyvinyliques, en particulier éther vinylique de 2-éthylhexyle (EHVE), éther vinylique d'octadécyle (ODVE), éther vinylique de cyclohexyle (CVE), éther monovinylique de cyclohexanediméthanol (CHMVE), éther vinylique de dodécyle (DDVE) ou éther monovinylique de diéthylèneglycol (MVE-2).

11. Procédé selon l'une des revendications précédentes, **caractérisé en ce que** l'encre d'imprimerie contient un ou plusieurs des silanes suivants : 3-aminopropyltriméthoxysilane, 3-aminopropyltriéthoxysilane, N-(n-butyl)-3-aminopropyltrimethoxysilane, aminosilane modifié avec un éther de polyglycol, N-aminoéthyl-3-aminopropylméthyldiméthoxysilane, 3-aminopropylméthyldiéthoxysilane, 3-uréidopropyltriéthoxysilane, N-aminoéthyl-3-aminopropyltriméthoxysilane, polytriméthoxysilane à fonctionnalité triamino, 3-(4,5-dihydro-imidazolyl)-propyltriéthoxysilane, 3-méthacryloxypropyltriméthoxysilane, 3-glycidyloxypropyltriméthoxysilane, 3-glycidyloxypropyltriéthoxysilane, 3-mercaptopropyltriméthoxysilane, polyéther-silane, vinyltrichlorosilane, vinyltriméthoxysilane, vinyltriéthoxysilane, vinyltris(2-méthoxyéthoxy)silane.

**12.** Procédé selon l'une des revendications précédentes, **caractérisé en ce que** l'encre d'imprimerie contient, comme photo-initiateur pour l'induction de la polymérisation radicalaire, un ou plusieurs des composés suivants : 2-benzyl-2-diméthylamino-1-(4-morpholinophényl)-butanone-1, oxydes de phosphine, en particulier oxyde de 2,4,6-triméthylbenzoyldiphénylphosphine, oxyde de 2,4,6-trimethylbenzoylphényléthoxyphosphine, oxyde de bis(2,4,6-triméthylbenzoylphénylphosphine), oxyde de bis(2,6-diméthoxybenzoyl)-2,4,4-triméthylpentylphosphine, 1-hydroxycyclohexylphénylcétone, 1-[4-(2-hydroxyéthoxy)-phényl)-2-hydroxy-2-méthyl-1-propan-1-one, 2-hydroxy-2-méthyl-1-phénylpropan-1-one, 1-hydroxycyclohexylphénylcétone, 1-(4-isopropylphényl)-2-hydroxy-2-méthylpropan-1-one, 2-méthyl-1-[4-(méthylthio)phényl]-2-morpholinopropanone-(1) ou dérivés de thioxanthone, en particulier 2-isopropylthioxanthone.

**13.** Procédé selon la revendication 12, **caractérisé en ce que** l'encre d'imprimerie contient des co-initiateurs, en particulier des amines.

**14.** Encre pour héliogravure pour une utilisation dans un procédé d'héliogravure rotative, l'encre d'imprimerie étant durcissable au moyen d'un rayonnement actinique avec polymérisation de son liant et contenant 20 - 75 % en poids, de préférence 30 - 70 % en poids d'un système de liant durcissable par rayonnement actinique, 2 - 25 % en poids, de préférence 4 - 15 % en poids d'un éther de vinyle, 0 - 45 % en poids d'un colorant, 2 - 15 % en poids, de préférence 2 - 10 % en poids d'un photo-initiateur radicalaire et 0 - 10 % en poids d'additifs, **caractérisée en ce que** la viscosité de l'encre d'imprimerie durcissable par rayonnement à 20°C et à un gradient de cisaillement de D = 100 s$^{-1}$ est inférieure à 300 mPas et la viscosité peut être réduite à une valeur inférieure à 100 mPas (D = 100 s$^{-1}$) par chauffage du cylindre d'impression jusqu'à 50°C, et l'encre d'imprimerie contient, comme additif pour améliorer l'adhérence sur des feuilles de matière plastique ou de métal, des silanes dans une proportion comprise entre 0,5 et 5 % en poids, de préférence 1-3 % en poids.

**15.** Encre pour héliogravure selon la revendication 14, **caractérisée en ce que** l'encre d'imprimerie contient, comme photo-initiateur pour l'induction de la polymérisation radicalaire, un ou plusieurs des composés suivants : 2-benzyl-2-diméthylamino-1-(4-morpholinophényl)-butanone-1, oxyde de 2,4,6-trimethylbenzoylphényléthoxyphosphine, 1-[4-(2-hydroxyéthoxy)-phényl]-2-hydroxy-2-méthyl-1-propan-1-one.

**16.** Encre pour héliogravure selon l'une des revendications 14 à 15, **caractérisée en ce que** l'encre d'imprimerie contient, comme liant de poids moléculaire bas, un ou plusieurs acrylates de polyester, acrylates de polyéther, y compris les types à modification amino, ou des acrylates d'uréthanne ayant un poids moléculaire inférieur à 1500 et une fonctionnalité acrylate d'au moins 2, de préférence de 3 à 4.

**17.** Encre pour héliogravure selon l'une des revendications 14 à 16, **caractérisée en ce que** le liant de l'encre d'imprimerie un ou plusieurs des monomères suivants : triacrylate de pentaérythritol (PETIA), y compris ses dérivés éthoxylés ou propoxylés (comme par exemple PPTTA), triacrylate d'isocyanurate de tris(2-hydroxyéthyle) (THEICTA).

**18.** Encre pour héliogravure selon l'une des revendications 14 à 17, **caractérisée en ce que** l'encre d'imprimerie contient, comme photo-initiateur pour l'induction de la polymérisation radicalaire, un ou plusieurs des composés suivants : oxydes de phosphine, en particulier oxyde de bis(2,4,6-triméthylbenzoylphénylphosphine), oxyde de bis(2,6-diméthoxybenzoyl)-2,4,4-triméthylpentylphosphine, 1-hydroxycyclohexylphénylcétone, 2-hydroxy-2-méthyl-1-phénylpropan-1-one, 1-(4-isopropylphényl)-2-hydroxy-2-méthylpropan-1-one ou des dérivés de thioxanthone.

**19.** Encre pour héliogravure selon l'une des revendications 14 à 18, **caractérisée en ce qu'**elle comprend des particularités selon l'une des revendications 1 à 13.

**20.** Substrat **caractérisé en ce qu'**il est imprimé avec un procédé d'impression selon l'une des revendications 1 à 13 et/ou avec une encre d'imprimerie selon l'une des revendications 14 à 19.